Europäisches Patentamt

European Patent Office

Office européen des brevets

(19)

(11) Publication number: **0 500 047 A2**

# EUROPEAN PATENT APPLICATION

(12)

(21) Application number: **92102683.7**

(22) Date of filing: **18.02.92**

(51) Int. Cl.5: **G03G 15/20, G03F 7/00**

(30) Priority: **19.02.91 JP 24929/91**
**03.07.91 JP 162891/91**
**22.01.92 JP 9546/92**

(43) Date of publication of application:
**26.08.92 Bulletin 92/35**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**
Applicant: **SEIKO INSTRUMENTS CO., LTD.**
**31-1, Kameido 6-chome, Koto-ku**
**Tokyo(JP)**

(72) Inventor: **Suzuki, Takashi**

**c/o Seiko Epson Corporation, 3-5, Owa**
**3-chome**
**Suwa-shi, Nagano(JP)**
Inventor: **Kobayashi, Atsushi**
**c/o Seiko Epson Corporation, 3-5, Owa**
**3-chome**
**Suwa-shi, Nagano(JP)**
Inventor: **Nakano, Yuko**
**c/o Seiko Epson Corporation, 3-5, Owa**
**3-chome**
**Suwa-shi, Nagano(JP)**

(74) Representative: **Blumbach Weser Bergen**
**Kramer Zwirner Hoffmann Patentanwälte**
**Radeckestrasse 43**
**W-8000 München 60(DE)**

(54) **Pressure transfer device for an image forming apparatus.**

(57) Disclosed is a pressure transfer device for an image forming apparatus such as a copier, printer, plotter, facsimile machine, etc., in which an image is transferred from a sheet-like photosensitive member (F) to a sheet-like transfer member (P) by pressing the photosensitive member and the transfer member against each other while passing them between a pair of pressure rollers (72, 73) after the photosensitive member has been image exposed and developed. The pair of pressure rollers (72, 73) is equipped with a elastic means (101) that comes into elastic rolling contact with the superposed photosensitive member (F) and transfer member (P). Thereby, a uniform pressure as well as a uniform temperature in the axial direction of the pressure rollers is achieved leading to an improved image quality.

FIG. 2

EP 0 500 047 A2

The present invention relates to a pressure transfer device employed in image forming apparatus such as copiers, printers, plotters, facsimile machines ect., that use so called "photosensitive transfer type heat developing materials" to form images.

An image forming device of this type is disclosed in JP-A-62-147461. This prior art device is a color copier comprising a photosensitive member supply section, an exposure section, a heat developing section, a pressure transfer section and a photosensitive member disposal section which are provided along a transport path. The photosensitive member supply section houses a film type photosensitive member rolled up on a core (roll), and it is configured such that it is capable of cutting the photosensitive member to the prescribed length and then supplying it to the exposure section. The exposure section receives light reflected by an original and exposes the photosensitive surface of the photosensitive member to form a latent image corresponding to the original. The heat developing section heat develops the latent image formed on the photosensitive member by heating the photosensitive member to 80° to 200°C for approximately 30 s. The pressure transfer section mates the photosensitive member with a transfer member made from paper, etc., transfers the image on the developed photosensitive member to the transfer member using pressure, and then separates the photosensitive member and the transfer member. In the photosensitive member disposal section, the photosensitive member from which the image has been transferred is successively ejected and stacked.

The photosensitive member employs a plastic film as a base material, on the surface of which are applied microcapsules charged with a photosensitive substance and a pigment. Using this photosensitive member, a photoreaction is initiated in the photosensitive substance in the exposure section (latent image forming), and this change of state is used to effect the pigment by means of heating in the heat developing section and causing it to become selectively hardened. In the pressure transfer section, the microcapsules are crushed, and the pigment that has not been hardened is transferred to the paper, whereby the output image is formed.

The pressure transfer section of this kind in prior art devices constitutes a pressure transfer device comprising a pair of left and right pressure rollers and a pair of upper and lower backup rollers, the letter pushing against the respective pressure rollers from behind. The mated or superposed photosensitive member and transfer member are pressed together as they pass between the pair of pressure rollers whereby the image is transferred. The backup rollers apply an even force to the pressure rollers to effect a uniform pressure on the pressure rollers in the axial direction from both sides. Since the pressure rollers are metal rollers made from carbon steel ect., a high pressure can be applied to them.

In this kind of prior art pressure transfer devices the following problems occur. Since the pressure roller is a rigid member made from a hard material such as carbon steel, if there should be any deviation in the cylindricity (3-5 $\mu$m) of a roller, then the pressure distribution on the photosensitive member and the transfer member becomes uneven which results in an uneven density of the output image and, thus, degrades the image quality. Further, since the transfer member, if it is not a special type of paper, may have a non-uniform thickness and uneven density of paper fibers, factors in the transfer member itself can cause an uneven pressure distribution even if the pressure rollers were sufficiently cylindrical.

It is known that by heating the photosensitive member and the transfer member during the transfer process, a sufficiently good image can be obtained at a relatively low pressure. The heating source is generally disposed inside the pressure roller so that, since the heat is applied to the photosensitive member and the transfer member from the heating source via the pressure roller, the temperature distribution will inevitably be uneven. Further, since the viscosity of the pigment or colorant depends on temperature, an uneven temperature distribution will cause areas that are easily transferred and areas that are not easily transferred, thus, resulting in uneven densities in the output image.

The present invention is intended to solve these problems and its purpose is to provide a pressure transfer device capable of applying an even pressure to the photosensitive member and the transfer member as they pass between two pressure rollers.

This object is achieved by a pressure transfer device as claimed in claim 1.

Specific embodiments of the invention are claimed in dependent claims.

When the pressure rollers are provided with an elastic means that comes into an elastic rolling contact with the superposed photosensitive member and transfer member, the pressure increases and the elastic means is greatly depressed where there are relative rises in the surface of a pressure roller or where the transfer member is thicker than at other portions, whereas the pressure drops and the elastic means is depressed only slightly where there are depressions in the surface of a pressure roller or where the transfer member is thinner than at other portions. Where the elastic means is greatly depressed, the contact surface area with the photosensitive member and the transfer member is relatively large, whereas at portions where the elastic means is depressed only slightly, the contact surface area with the photosensitive member and the transfer member is relatively small. In case of a large contact surface area the force per unit area, i.e. the pressure, is relatively low even if the force should be large, and in case of a small contact surface area, the pressure is relatively high even if the force is low. Therefore, the pressure applied to the photosensitive member and the transfer member by the pressure rollers becomes uniform overall.

It is also known that as the temperature of the resin or rubber used for the elastic means increases, the modulus of elasticity of the elastic means decreases. Therefore, the modulus of elasticity of the elastic means in high temperature regions of the pressure roller equipped with a heating source is relatively low whereas it is relative high in low temperature regions. This causes the elastic member to be depressed relatively little in high temperature regions of the pressure roller and to be depressed more in low temperature regions. In regions where the elastic means is depressed relatively little, the contact surface area with the photosensitive member and the transfer member is relatively small and in regions where the elastic means is depressed more, the contact surface area is correspondingly greater. This means that the heat transfer area is smaller in high temperature regions and larger in low temperature regions. Therefore, the heat applied to the photosensitive member and the transfer member becomes uniform overall.

By providing the pressure transfer device with a pressure release means that presses the two pressure rollers together in a power ON state and releases the pressure in a power OFF state, the application of pressure over long periods to the same area of the elastic means of the pressure rollers can be avoided to prevent a permanent deformation of parts of the elastic means.

Embodiments of the invention will be described in detail below with reference to the drawings, in which:

Fig. 1    is a diagrammatic view of the overall structure of a color copier to which the pressure transfer device of the invention has been applied,

Fig. 2    is a diagrammatic view of the pressure transfer device according to a first embodiment of the invention,

Fig. 3    is a diagrammatic view showing a first modification of the first embodiment,

Fig. 4    is a diagrammatic view showing an embodiment of the pressure transfer device of the invention to which a first kind of pressure release means has been added,

Fig. 5    is a diagrammatic view of a pressure transfer device of the invention to which another kind of pressure release means has been added,

Fig. 6    is a diagrammatic view of a second modification of the first embodiment,

Fig. 7    is a diagrammatic view of a third modification of the first embodiment,

Fig. 8    is a diagrammatic view of a second embodiment of the invention,

Fig. 9    is a diagrammatic view of a modification of the second embodiment,

Fig. 10   is a diagrammatic view of a third embodiment of the invention,

Fig. 11   is a diagrammatic view of a first modification of the third embodiment,

Fig. 12   is a diagrammatic view of a second modification of the third embodiment and

Fig. 13   is a diagrammatic view of a third modification of the third embodiment.

To facilitate understanding of the present invention, first the overall structure of a color copier as an example of an image forming apparatus to which the present invention can be applied, will be explained in detail.

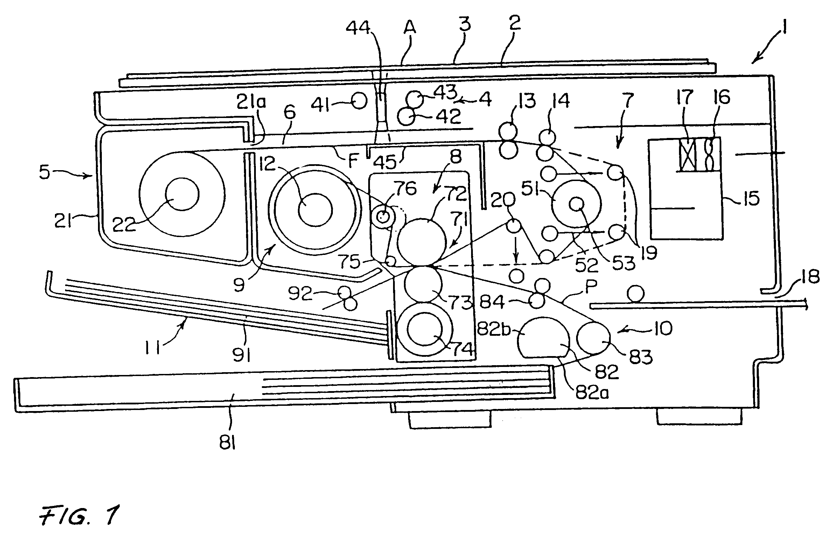

Fig. 1 is a cutaway side view of a color copier employing an embodiment of the invention. As shown in the Figure, the top surface of a copier main unit 1 is a glass original table 2, and above that an original table cover 3 is attached in such a way that it can be moved between a closed position as shown and an upright opened position. An original A used as the input image is set on the original table 2, and it is copied while being held down by the original table cover 3.

An exposure section 4 is positioned inside the main unit 1 below the original table 2, and a supply section 5, which supplies the photosensitive member F, is positioned up-stream from the exposure section 4. The supply section 5 is a magazine type unit that houses the photosensitive member F, and it is configured such that it can be freely attached to and detached from the main unit 1. The photosensitive member F supplied from the supply section 5 to the main unit 1 is transported along a transport path 6 as required and sequentially faces the exposure section 4, a heat developing section 7, a pressure transfer section 8 and a photosensitive member disposal section 9. The transport path 6 turns back in the heat developing section 7, and each section is efficiently positioned in the main unit 1 to keep the main unit compact.

A latent image is formed on the photosensitive member F, which is transported from the supply section 5 along the transport path 6, by exposure to the input image in the exposure section 4, after which the latent image is heat developed by heating it to approximately 150°C in the heat developing section 7. The photosensitive member F, which has undergone developing, is then aligned with a paper P as the transfer member, in the pressure transfer section 8, and the developed image is pressure transferred to the paper P.

Finally, the photosensitive member F and paper P are separated and the photosensitive member F is collected by rolling it up in the photosensitive member disposal section 9. The paper P is supplied to the pressure transfer section 8 from a paper supply section 10 at the bottom of the main unit 1, and paper P onto which the output image has been transferred is discharged to the paper outlet section 11.

The photosensitive member F is comprised of a polyethylene terephthalate (PET) film as a base material and microcapsules charged with a coloring material and a photosensitive substance, which is made up of a photosensitive silver halide, a reducing agent and a polymer compound, and applied to the surface of the base material. The photosensitive substance performs a trigger-like function in that it undergoes a photoreaction that results in hardening of the coloring material during the development. The coloring material is provided in the colors yellow, magenta and cyan, and microcapsules of these three colors in which these coloring materials are charged are abundantly applied to the surface of the PET in a mixed condition.

In the image forming process in this embodiment the photosensitive material F undergoes a photoreaction in the exposure section 4 (formation of latent image), and the resulting change of state affects the coloring material when heated in the heat developing section 7 so that it is selectively hardened (developing). The microcapsules are crushed in the pressure transfer section 8, whereby the coloring material that has not hardened is transferred to the paper P to form the output image.

The left side of the main unit 1 shown in Fig. 1 is the supply section 5. It comprises a black box magazine 21 which can be attached to or detached from the main unit 1 by suitable means not shown. By means of this attachment and detachment, unexposed photosensitive member F can be mounted and exposed photosensitive member F can be re-wound into the magazine 21 and disposed off. The photosensitive member F is formed as one long piece and is rolled up on the supply roller 22 housed in the magazine 21. The photosensitive member F is continuously unrolled from the supply roller 22 with its photosensitive side facing upward and supplied through a slit 21a in the magazine 21 to the exposure section 4 located downstream.

The exposure section 4 comprises R, G and B lamps i.e., a red lamp 41, a green lamp 42 and a blue lamp 43, as light sources, a converging lens 44 and an exposure table 45, and the photosensitive member F travels on top of the exposure table 45. The red lamp 41, green lamp 42 and blue lamp 43 irradiate light toward the original on the original table 2 by means of a reflector (not shown), and the light reflected by the original A is projected on the photosensitive surface of the photosensitive member F by the converging lens 44 and a shutter (not shown), whereby exposure of the photosensitive member F is performed. In this case, the original A moves forward and backward together with the original table 2, and the photosensitive member F is transported at the same speed, thus implementing a so-called "scan exposure system".

The heat developing section 7 is provided with a heating roller means 51, which serves as the heating member, and comprises a main roller unit 52 supported on a frame (not shown) of the main unit 1 so that it can rotate freely, and a halogen lamp heater 53 mounted inside the main roller unit 52. The surface temperature of the main roller unit 52 is controlled by switching this halogen lamp heater 53 on and off so that the temperature is 150 ± 3°C (155°C in some cases), and the rear surface of the photosensitive member F comes into direct contact with the surface of the main roller unit 52. The photosensitive member F is wound around the main roller unit 52 at a prescribed angle, it is heated at a prescribed developing temperature for a prescribed time period, and then it makes a U turn back toward the pressure transfer section 8.

The pressure transfer section 8 comprises the pressure transfer device 71 made up of an upper roller 72, a middle roller 73 and a lower roller 74, and is also equipped with a separation roller 75 and a pinch roller 76. The photosensitive member F and the paper P forming the transfer member, in a superposed condition, are passed between the upper roller 72 and the middle roller 73 in order to transfer the image from the developed photosensitive member F to the paper P. The separation roller 75 is disposed near the pressure transfer device 71 on the downstream side and bends the transport path of the photosensitive member F at an acute angle to the inside, whereby the photosensitive member F and the paper P are forcibly separated from each other. The pinch roller 76 moves to the position indicated by a dashed line in Fig. 1 during transport of the photosensitive member F so that the photosensitive member F is sandwiched between the pinch roller 76 and the upper roller 72 and a transport force applied to it. The separated photosensitive member F is transported to the photosensitive member disposal section via the pinch roller 76. The transfer temperature in case of this embodiment is 70±°C.

The photosensitive member disposal section 9 has a take-up roller 12 on which used photosensitive member F is rolled up in a roll. When all of the photosensitive member F has been rolled up on the take-up roller 12, a clutch is disengaged to allow take-up roller 12 to rotate freely. In this condition, the supply roller 22 of the supply section 5 is driven in the opposite direction, and ultimately the used photosensitive member F is recollected in the magazine 21.

The paper supply section 10 comprises a paper cassette 81, which supplies the paper P as cut sheet paper, a half-moon roller 82, which feeds out the paper from the paper cassette 81 one sheet at a time, a guide roller 83, which changes the path that the paper P follows, and a paper supply roller means 84, which guides the paper P that has been fed out to the pressure transfer section 8. The paper cassette 81 is configured such that it can be freely attached to and detached from the main unit 1, and multiple cassettes are provided to accommodate various sizes of paper. The half-moon roller 82 has a rubber surface around its perimeter which comprises a straight part 82a and a curved part 82b. The transition part between the straight part 82a and the curved part 82b catches the leading edge of the paper P, and the following curved part 82b feeds the paper P until its leading edge reaches the paper supply roller means 84. Supply of the paper P is initiated in synchronism with the transport of the photosensitive member F so that the paper P is aligned with the exposed part of the photosensitive member F.

The paper outlet section 11 comprises an ejected paper cassette 91, which holds the paper P to which an image has been transferred, and a paper eject roller means 92, which guides the paper P from the transfer section 8 to this paper cassette 91. The paper eject roller means 92 is configured such that it tends to feed slightly more than the paper supply roller means 84, and the resulting slip rotation feeds out the paper P while also applying tension to the paper P so that it will not wrinkle or become jammed during pressure transfer.

A feed roller 13 and a tension roller 14 are disposed between the exposure section 4 and the heat developing section 7. The feed roller 13 keeps the transport speed of the photosensitive member constant in the exposure section and the tension roller 14 absorbs any slack and prevents the occurrence of rinkles in the photosensitive member F subsequent to the heat developing section 7.

In the Figure, 15 is an exhaust unit comprising an exhaust fan 16 and a gas filter 17, and it exhausts heat and gas generated inside the main unit 1 through the gas filter 17 to the outside. Further, numeral 18 in the Figure indicates a manual paper supply opening for manually supplying paper P.

In the pressure transfer device 71 the upper roller 72 is fixed, and a uniform pressure is applied by the lower roller 74 via the middle roller 73, whereby a reciprocal holding force is applied to the photosensitive member F and the paper P disposed between the upper roller 72 and the middle roller 73. The lower roller 74 is in contact with the bottom part of the middle roller 73 in order to apply a uniform pressure.

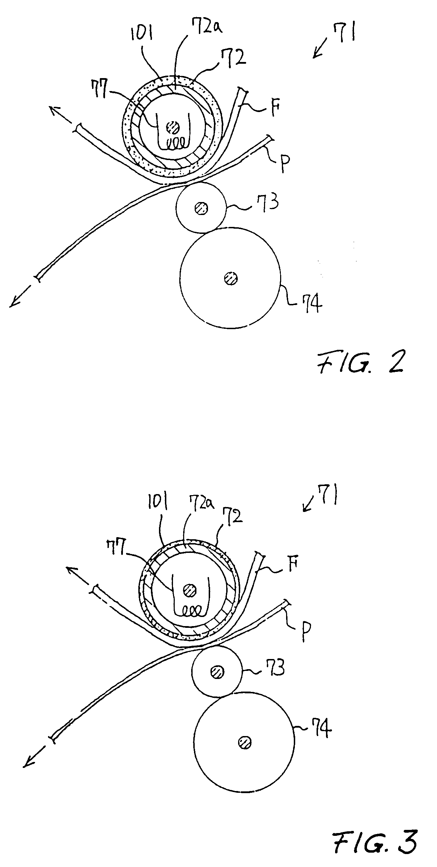

Inside the upper roller 72 a halogen lamp heater 77 (Fig. 2) serving as a heating source is provided to heat the photosensitive member F and the paper P to the transfer temperature of 70±3°C. As mentioned before, this heating (increased temperature) allows using a relatively low pressure for crushing the microcapsules on the photosensitive member F. As described above, transfer of the image from the photosensitive member F to the paper P is performed by heating and applying pressure with the upper roller 72 and the middle roller 73 having a unique structure to provide for a uniform pressure distribution on the photosensitive member F and the paper P in the axial direction.

Fig. 2 shows a first embodiment of the pressure transfer device according to the invention. As shown in the Figure, the upper roller 72 comprises a polyurethane rubber coating which serves as elastic member 101, covering the surface of a roller base unit 72a. It is this elastic member 101 of the upper roller 72 that comes into rolling contact with the photosensitive member F. The polyurethane rubber has a hardness of 98 JIS A and is approximately 1mm thick in order to have sufficient elasticity. In this embodiment, polyurethane rubber is used but other materials that exhibit rubber elasticity can also be used such as silicon rubber, natural rubber, styrene-butadiene rubber, butadiene rubber, ethylene propylene rubber and epichlorohydrin rubber, and such resins as nylon 66, polyacetal and polyisocyanate can be used.

Regarding the hardness and thickness of the elastic member 101, the improvement of an uneven density in the output image is generally greater as the softness and thickness are increased, but the pressure required to achieve the appropriate density is also increased. In this embodiment, the diameter of the upper roller 72 is 30mm, that of the middle roller 73 is 20mm, the upper roller is heated to 70°C and an overall force of about 3000 N (300kp) is applied between the upper roller 72 and the middle roller 73. The lower the overall force, the simpler the device configuration can be made, but a device can be practically configured such that is capable of forces up to 10kN (1000 kp). As the elastic member 101 becomes thicker, the transmission of heat from the halogen lamp heater 77 is diminished, thus making it difficult to control the temperature of the upper roller 72. TABLE 1 shows the results of an experiment performed by changing the heating temperature of the upper roller 72 to determine (practical) relationships between the hardness and thickness of the elastic member 101 that would maintain a highly even density condition for overall forces of less then 10kN.

5

TABLE 1

| Roller Temperature | Elastic Member Hardness (JIS A) | Thickness (mm) |
|---|---|---|
| 30°C | 99 | 2 - 5 |
| 30°C | 98 | 0.5 - 5 |
| 30°C | 95 | 0.2 - 2 |
| 30°C | 90 | 0.02 - 1 |
| 50°C | 99 | 2 - 5 |
| 50°C | 98 | 0.5 - 5 |
| 50°C | 95 | 0.2 - 3 |
| 50°C | 90 | 0.02 - 1.5 |
| 70°C | 99 | 2 - 5 |
| 70°C | 98 | 0.5 - 5 |
| 70°C | 95 | 0.2 - 4 |
| 70°C | 90 | 0.02 - 2 |

As can be seen from TABLE 1 by appropriately changing the hardness of the elastic member 101 at each of the heating temperatures of the upper roller, the elastic member can withstand actual use at thicknesses ranging from 0.02 to 5mm.

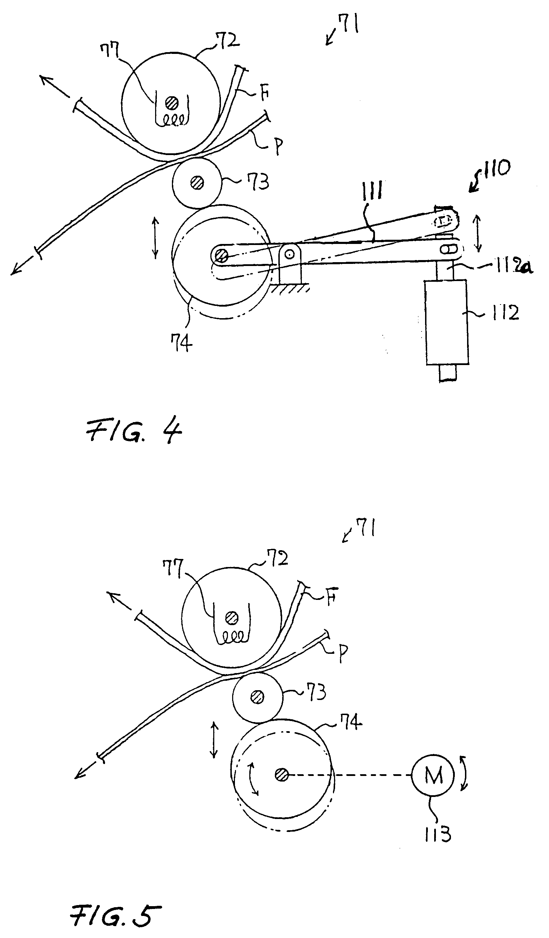

A modification of the first embodiment, which is based on the results of such experiments is shown in Fig. 3. In this case the elastic member 101 is formed as a thin film covering the surface of the roller base unit 72a of the upper roller 72. This elastic member 101 is made from the rubber or resin materials mentioned above and has a thickness from 30 to 100$\mu$m. With this modification it was experimentally confirmed that there was an absorption allowance of up to 10 $\mu$m in the cylindricity of the roller base unit 72a.

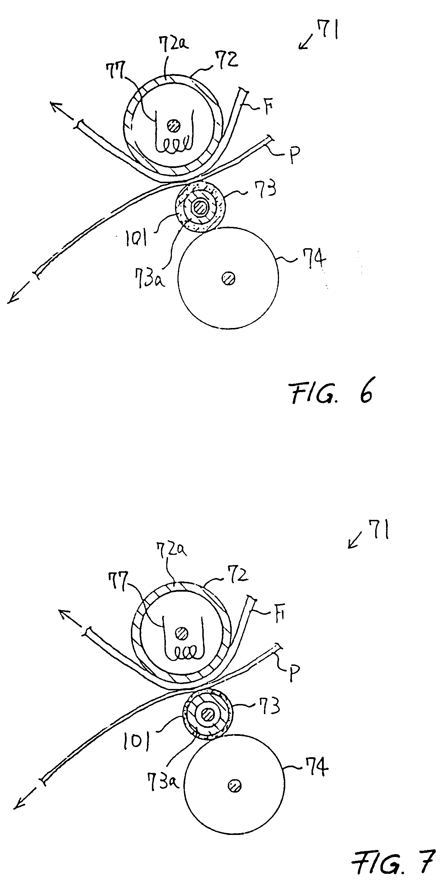

Figs. 4 and 5 show pressure release means applicable to this embodiment. The pressure release means 110 shown in Fig. 4 comprises a seesaw arm 111 having a middle portion pivotably fixed to the device frame. The supporting shaft of the lower roller 74 is attached to one end of the seesaw arm 111 while the plunger 112a of an electro magnetic solenoid 112 is attached to the other end. In the rejected position of the plunger 112a the lower roller 74 is pressed against the middle roller 73 at a prescribed pressure and in the extended position, contact of the lower roller 74 with the middle roller 73 is released. This extension and retraction of the plunger 112a of the solenoid 112 is controlled so that the plunger is in its retracted position when the power source of the color copier is ON and in the extended position when the power source is OFF.

Therefore, when the power source is ON, the upper roller 72 and the middle roller 73 are pressed against each other, and when the power is OFF they are released such that they do not press against each other. This prevents the two rollers 72 and 73 from being pressed against each other for long periods when the rotation of the two rollers 72 and 73 is stopped, thus avoiding permanent depression of parts of the elastic member 101 on one of the two rollers (or both rollers as will be explained later). That is, unevenness of the elastic member 101 itself is prevented.

The pressure release means shown in Fig. 5 comprises a step motor 113 and a power transmission means (not shown) which transmits the rotational force of the step motor 113 to eccentric means (not shown) supporting the lower roller 74. The eccentric rotation of the eccentric means in this configuration realizes a continuous repetition of the pressed condition and a released condition between lower roller 74 and middle roller 73. In this case, the pressure can be appropriately controlled by the angle of rotation of said eccentric support means for the lower roller 74.

In the embodiment described above the pressure transfer device 71 comprises an elastic member 101 on the surface of the roller base unit 72a of the upper roller 72. The upper roller 72 can be made to come into elastic rolling contact with the photosensitive member F without interfering with the heating of the photosensitive member F and the paper P. The rolling contact is performed while the prescribed pressure is being applied, and even if there should be a deviation in the cylindricity of the roller base unit 72a, i.e., minute unevenness in the surface of the roller base unit 72a, or if there should be an unevenness in the paper P, this is absorbed and a uniform pressure applied to the photosensitive member F and the paper P in the axial direction of the roller. That is, in the rolling condition, if there is a protruding part on the surface of the roller base unit 72a (or a protruding part on the paper P), the elastic member 101 will be depressed and becomes thinner, thus increasing the contact surface area between the elastic member 101, the photosensitive member F and the paper P. On the other hand, if there should be a depression either in the roller base unit 72a or the paper P, the contact surface area between the elastic member 101, the photosensitive member F and the paper P will decreased. This means, that when nearly the same force is applied to both, depressions and protrusions, the pressure in regions with a large contact area is relatively small and that in regions with a small contact area relatively large. Therefore, nearly the same pressure is applied to all parts of the photosensitive member F and the paper P even if there should be unevenness in the surface of the roller base unit 72a or the paper P.

It is known, that the higher the temperature of the rubber or resin used for the elastic member, the lower its modulus of elasticity becomes. The photosensitive member F and the paper P are heated by the halogen lamp heater 77 inside the upper roller 72 while being pressed together. The heat is transmitted from the roller base unit 72a of the upper roller 72 to the photosensitive member F and the paper P via the elastic member 101. If the temperature distribution on the elastic member 101 is non-uniform, the modulus of elasticity of the elastic member 101 will also be non-uniform, namely higher where the temperature is lower and vice versa. Where the modulus of elasticity of the elastic member is relatively high, i.e. where the temperature is relatively low, the elastic member is more easily depressed whereas, where the modulus of elasticity is relatively low because of a relatively high temperature the elastic member is not easily depressed. Due to that, the contact surface area becomes relatively large in low temperature regions and relatively small in high temperature regions. Since the contact surface area and the area of heat transfer are equivalent, heat is easily transferred in low temperature regions and not easily transferred in high temperature regions. Therefore, even if the surface temperature of the elastic member 101 is not uniform, all areas of the photosensitive member F and the paper P will be heated to the same temperature.

Since the photosensitive member F and the paper P are uniformly heated and pressed together by the upper roller 72 in cooperation with the middle roller 73 in the described embodiment, an uneven density of the output image is prevented and an improved image quality achieved.

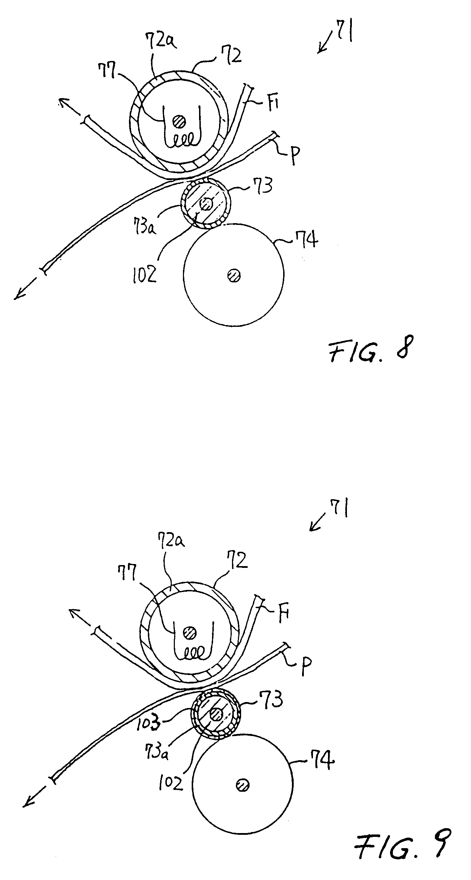

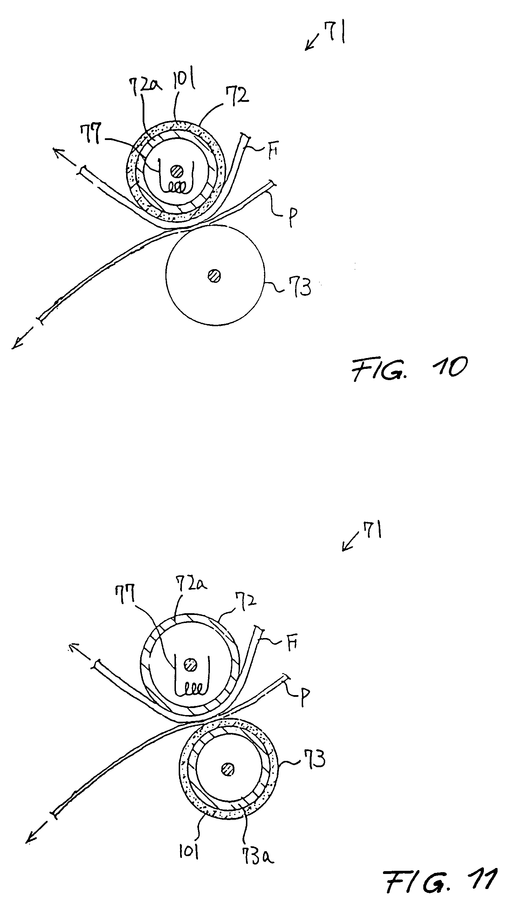

In the embodiment described above, the elastic member 101 is disposed on the roller base unit 72a, i.e. part of the upper roller 72. The same effect can be obtained by providing the elastic member 101 on the middle roller 73. Fig. 6 shows a configuration where a roller base unit 73a of the middle roller 73 is covered with an approximately 1mm thick elastic member 101 made of rubber or resin, and Fig. 7 shows a configuration where the roller base unit 73a is covered with an elastic member 101 of rubber or resin having a thickness of approximately 30 to 100 $\mu$m. In these cases heating may be performed from the paper P side in contrast to the forgoing embodiment where it is performed from the photosensitive member F side. However, since the photosensitive member F and the paper P are thin, there will be no significant difference between these two embodiments even if the heating is made from the photosensitive member F side as shown in the Figure.

The elastic member 101 on middle roller 73 in Fig. 6 can be formed by use of a metal mold and subsequent finishing of the surface of the elastic member for instance by means of cutting to determine the thickness of the elastic member. This method for forming the elastic member 101 is preferable when it is intended to be relatively thick. In the case of Fig.7 the elastic member 101 may be formed by spraying an elastic material onto the surface of roller base unit 73a resulting in thin elastic layer on the surface of middle roller 73. This latter method for forming the elastic member 101 is preferable when it is intended to be rather thin.

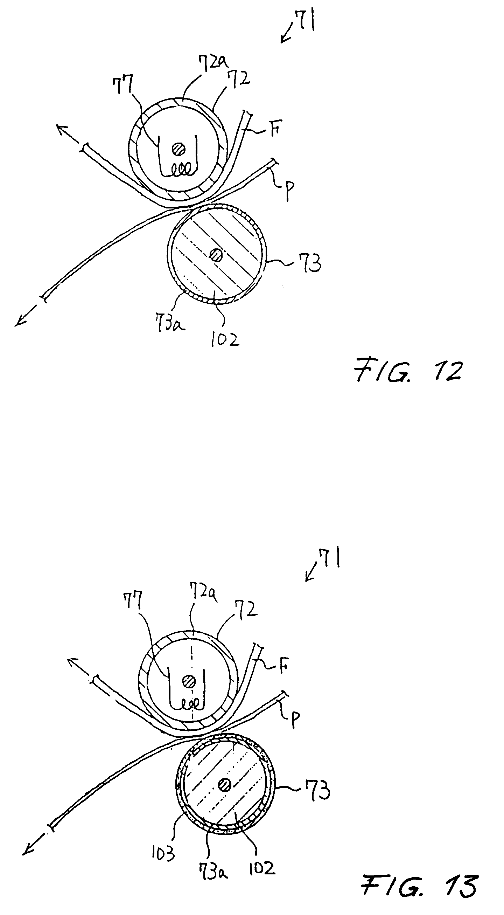

Fig. 8 shows a second embodiment of the present invention. In this embodiment, the roller base unit 73a of the middle roller 73 itself serves as the elastic member. This roller base unit 73a is a thin steel plate formed in the shape of a pipe such that it becomes slightly deformed when a prescribed pressure is applied to a certain part. Therefore, as in the case of the elastic member 101 formed from rubber, ect. in the first embodiment, a uniform pressure can be applied to the photosensitive member and the paper P. In this case, the inside of the roller base unit 73a is preferably filled with a support member 102 made from a material such as aluminum, brass and resin that is softer than the material of the roller base unit 73a, whereby an excessive deformation of the roller base unit 73a is inhibited.

Fig. 9 shows a modification of the second embodiment wherein the surface of the roller base unit 73a is covered with an elastic thin film 103 made from thin-film rubber, ect. By this means, the combined effect of the elasticity of the roller base unit 73a and that of the elastic thin film 103 makes it possible to apply an even more uniform pressure to the photosensitive member F and the paper P.

Figs. 10 to 13 show a third embodiment of the invention. Unlike the first and second embodiments, the lower roller 74 is omitted in this embodiment. In the pressure transfer device shown in Fig. 10, the elastic member 101 is part of the upper roller 72 as with the embodiment of Fig. 2, while in the pressure transfer device shown in Fig. 11 the elastic member 101 is part of the middle roller 73 as with the embodiment of

7

Fig. 6. In the pressure transfer device shown in Fig. 12, the roller base unit 73a of the middle roller 73 is structured like that in the embodiment of Fig. 8, while in the embodiment of Fig. 13 the middle roller 73 is structured like that of the embodiment of Fig. 9.

Since the upper roller 72 or the middle roller 73 has or is an elastic member as described above, a uniform pressure can be achieved with high precision even without backup pressure from the lower roller 74.

In the above embodiments the elastic member is disposed on either the upper roller 72 or the middle roller 73, but it may be disposed on both rollers. Furthermore, the halogen lamp heater is disposed in the upper roller 72 but it may be disposed in the middle roller 73 or the entire pressure transfer device can be housed in a case and the inside of the case maintained at a prescribed temperature. Also, heating of the photosensitive member F and paper P is not necessarily required for image transfer since good transfer can be achieved without heating by increasing the pressure.

Further, it goes without saying that the invention is applicable not only to color copiers but to varies kinds of image forming apparatus like printers, plotters, facsimile machines, electronic cameras ect.

## Claims

1. A pressure transfer device for an image forming apparatus, in which an image is transferred from a sheet-like photosensitive member (F) to a sheet-like transfer member (P) by pressing the photosensitive member and the transfer member against each other while passing them between a pair of pressure rollers (72, 73) after the photosensitive member has been image exposed and developed, characterized in that the pair of pressure rollers (72, 73) is equipped with an elastic means (101; 73a) that comes into elastic rolling contact with the superposed photosensitive member (F) and transfer member (P).

2. The pressure transfer device of claim 1, wherein a pressure release means (110) is provided for selectively pressing the pair of pressure rollers (72, 73) against each other or releasing the pressure.

3. The pressure transfer device according to claim 1 or 2, wherein said elastic means (101) is an elastic member covering the surface of a roller base unit (72a; 73a) of at least one of said pressure rollers (72, 73).

4. The pressure transfer device according to claim 3, wherein said elastic member (101) is made from rubber or resin.

5. The pressure transfer device according to claim 4, wherein the thickness of the elastic member is 0.02 to 5mm.

6. The pressure transfer device according to claim 4 or 5, wherein the hardness of the elastic member (101) is 90 to 99 JIS A.

7. The pressure transfer device according to any of the preceding claims, wherein the elastic means comprises a pliant roller base unit (73a) of at least one of said pressure rollers (72, 73).

8. The pressure transfer device according to claim 7, wherein the roller base unit (73a) is formed in the shape of a pipe having an internal support member (102) made from a material softer than that of the roller base unit.

9. The pressure transfer device according to claim 2, wherein said pressure release means (110) releases said pair of pressure rollers (72, 73) when the power is off so as to avoid permanent set of said elastic means (101).

FIG. 1

FIG. 2

FIG. 3

FIG. 4

FIG. 5

11

EP 0 500 047 A2

FIG. 6

FIG. 7

12

FIG. 8

FIG. 9

FIG. 10

FIG. 11

FIG. 12

FIG. 13

15